Europäisches Patentamt

(19) European Patent Office

Office européen des brevets

(11) Publication number: **0 311 245 B1**

# EUROPEAN PATENT SPECIFICATION

(12)

(45) Date of publication of patent specification: **10.06.92** (51) Int. Cl.⁵: **H01L 29/78**, H01L 21/84, H01L 23/00

(21) Application number: **88307863.6**

(22) Date of filing: **25.08.88**

(54) Semi-conductor devices having a great radiation tolerance.

(30) Priority: **04.09.87 GB 8717041**

(43) Date of publication of application:
**12.04.89 Bulletin  89/15**

(45) Publication of the grant of the patent:
**10.06.92 Bulletin  92/24**

(84) Designated Contracting States:
**DE FR NL**

(56) References cited:
US-A- 3 890 632
US-A- 4 015 279
US-A- 4 054 895

**IEEE ELECTRON DEVICE LETTERS, vol. EDL-3, no. 7, July 1982, pages 195-197, IEEE, New York, US; B.Y. TSAUR et al.: "Effects of ioniz-ing radiation on n-channel MOSFET's fab-ricated in zone-melting-recrystallized Si films on SiO2"**

(73) Proprietor: **PLESSEY OVERSEAS LIMITED**
**Vicarage Lane**
**Ilford Essex IG1 4AO(GB)**

(72) Inventor: **Alderman, John Charles**
**27, Brackley Road**
**Towcester Northants(GB)**

(74) Representative: **Hoste, Colin Francis**
**The General Electric Company p.l.c. Central**
**Patent Department (Wembley Office) Hirst**
**Research Centre East Lane**
**Wembley, Middlesex HA9 7PP(GB)**

# Description

This invention relates to semi-conductor devices and has for its object the provision of such a device having an improved radiation tolerance. In particular, the invention relates to CMOS. (Complementary Metal Oxide Silicon) devices, the radiation tolerance of which devices is relatively low.

SOS (Silicon on Sapphire) devices provide one way in which the radiation tolerance of a semiconductor device may be improved. However, when small geometry (of the order of 1 micron), large scale (several thousand transistor) devices are fabricated, there are problems associated with the sapphire/silicon interface. Known alternative forms of SOI (Silicon on Insulator) provide some improvement. For example, as described by BT Tsaur et al (MIT, EDL3, No. 7 1982 pg 195) bias of the back interface (the substrate) is possible with reasonable voltages. T Ohno et al (NTT, Paper 4.4, 1986 IEEE SOS/SOI technology workshop on oxygen implantation) describe a screening/field shielding layer formed of a polysilicon sidewall in electrical contact with the bulk substrate perimetrically of an N-channel device to prevent radiation turning on the peripheral transistors of the device.

It will be appreciated that, using the latter arrangement, it is not possible separately to bias the sidewalls or the bulk substrate base. Other problems include, processing complexity; step coverage problems, depth of field requirements, difficulties when small geometry is involved, and potential gate oxide integrity problems (this being a standard problem in SOS technology).

According to the present invention, a semiconductor device comprises a layer of silicon on an insulating layer and a bulk substrate, the insulating layer electrically insulating the silicon layer from the bulk substrate, the silicon layer having a conductive, non-contiguous sidewall, also insulated from the bulk substrate by the insulating layer.

The device conveniently comprises a plurality of the silicon layers forming islands.

The insulating layer is preferably a layer of silicon oxide.

The or each non-contiguous conductive sidewall may surround its respective layer.

The sidewall or sidewalls are preferably of polysilicon and may be doped, if desired.

Contact may be formed between a sidewall and a terminal e.g. the source or drain of an active device on the silicon chip thereby, in use, to apply a bias potential to the sidewall.

The invention also provides a method of making a semiconductor device comprising the steps of providing a sacrificial (at least in part) insulating coating on the exposed upper and side surfaces of a silicon layer mounted on an insulating layer on the surface of a bulk substrate, depositing polysilicon on the silicon layer and the surrounding insulating layer, and etching away the polysilicon to uncover the sacrificial insulating coating on the upper surface of the silicon layer but to leave a sidewall of the polysilicon separated from the silicon layer by the sacrificial insulating coating.

Preferably, a silicon bulk substrate with a buried oxide insulating layer adjacent one surface is then etched to provide a plurality of the silicon layers in the form of islands of silicon separated by valley regions of the oxide insulating layer, on the bulk substrate.

The invention will be described further by way of example with reference to the accompanying drawings in which:-

Figure 1 to 5 and Figures 7 and 8 are diagrammatic cross-sectional sketches illustrating some of the steps involved in the manufacture of a semiconductor device in accordance with the invention; and

Figure 6 and 9 are diagrammatic detached plan views of the device at corresponding stages of manufacture.

It will be appreciated that known masking, etching, step and repeat technologies are applicable in the manufacture of the device and only additional steps will be described in any detail.

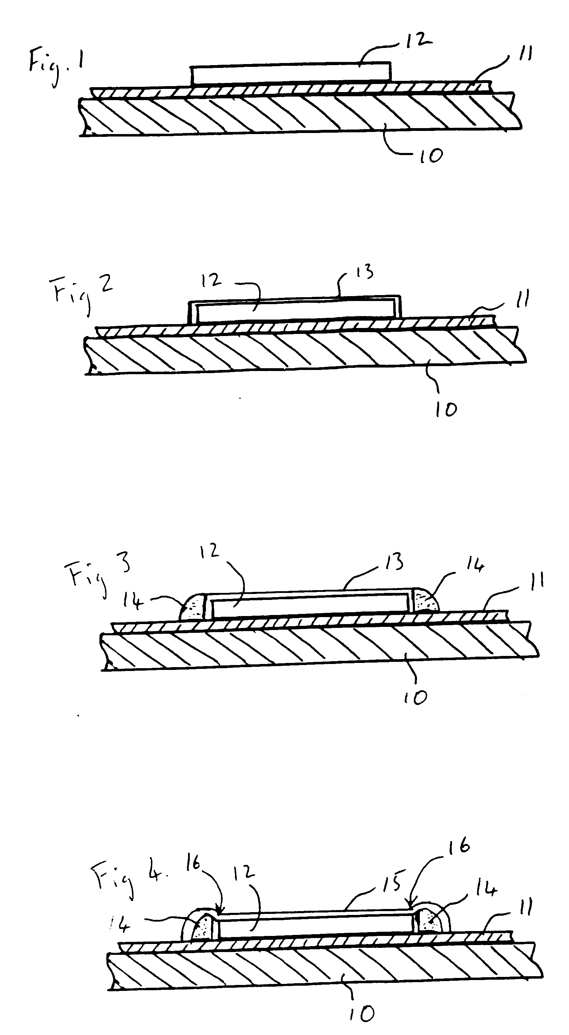

Referring to the drawings, Figure 1 shows a substrate 10 having an insulating surface 11 which may be a silicon oxide layer bearing a silicon layer 12 on its upper surface. The layer 12 may be one of a plurality of such "islands" formed by etching according to known SOI techniques.

Conventional doping and like steps will not be described in detail but, for example, the silicon layer (before or after the above mentioned steps) may be doped.

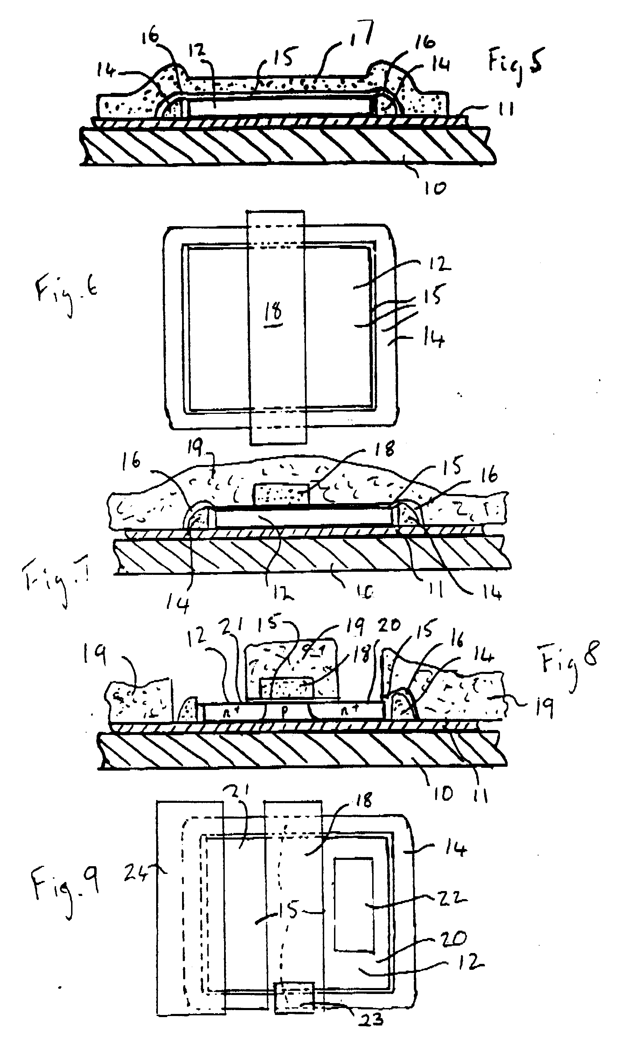

As shown in Figure 2, an oxide coating 13 is grown on the exposed surfaces of the layer 12. This coating is sacrificial, at least in part, and is grown only to permit the formation of the non-contiguous sidewalls to the layer 12 which are separated from the layer 12 by remanent parts of the oxide coating 13.

Polysilicon is deposited on the oxide coating 13 on the upper and side walls of the layer 12 and on the insulating surface 11 peripherally of the layer 12. As shown in Figure 3, this polysilicon is then etched or otherwise removed to uncover the sacrificial oxide coating 13 on the upper surface of the layer 12 but to leave a sidewall 14 peripherally of the layer 12 but non-contiguous therewith separated from the layer by that portion of the oxide coating 13 on the side walls of the layer 12.

The sacrificial oxide layer 13 on the upper surface of the layer 12 is then removed and a layer of oxide 15, as shown in Figure 4, is grown on the upper surface of the layer 12 and extending over the sidewalls 14. The layer 15 is to form the gate oxide layer in use so it's formation is accurately controlled.

Fortuitously, as the layer 15 is grown, due to the nature of the oxidation polysilicon, that portion extending over the edges of the layer 12 and the sidewalls 14 forms a rounded shoulder 16 of slightly greater layer thickness which shoulder improves the integrity of the oxide layer at the corners of the silicon layer 12 (as compared to the thickness of oxide at the edges of the layer 12 when growing a gate oxide layer).

Thereafter, a layer of polysilicon or other gate material is deposited over the silicon layer 12 and the sidewalls 14 as seen in Figure 5, which layer is then masked and etched to form the gate 18 of the semiconductor device. The extent of the gate 18 can readily the seen from the detached plan view of Figure 6 but it will be realised that the gate 18 is insulated from the silicon layer 12 and from the sidewalls 14 by the oxide layer 15.

Doping may be effected at this stage of the process.

A layer 19 of interlevel material is deposited (see Figure 7) on the surface of the device and is then masked and etched away as shown in Figure 8. Etching is also effected, in unmasked areas, of the oxide layer 15 to expose, in part, the conductive sidewall 14 and areas 20 and 21 of the layer 12. The doped areas 20 and 21 of the layer 12 from the contact areas of the device.

As shown in Figure 9, appropriate areas may be metallised to provide contacts. Contact hole 22 may provide, for example, access to the source region of the layer 12; contact hole 23, access to the gate 18; and contact hole 24, access to the drain area of the device and to the perimetric conductive sidewall 14 thus permitting the sidewall, in this case, to be tied to the same potential as the drain. The contact hole 22 must and the contact hole 23 may be nested.

It will be appreciated that the area 21 could constitute the source of the device in which case, the perimetric sidewall 14 would, in use, be tied to the same potential as the source.

The bulk substrate 10 may, of course, be biased independently of the sidewall 14.

The sidewall 14 extends perimetrically of each of the layers 12. If plurality of semi-conductor devices are provided on one of the layers 12, at least the layer 12 perimetric sidewall surrounds each device. Masked etching, at the stage illustrated in Figure 3, could be used to provide an additional sidewall 14 on two or on three sides of desired semi-conductor devices of the layer 12.

The invention is not confined to the precise details of the foregoing example and variations may be made thereto. For instance, it is possible to employ silicon nitride as an insulating layer rather then silicon oxide. Other variations are possible within the scope of the present invention as defined in the appended claims.

It will be seen that a semiconductive device may be formed, in accordance with the present invention, in which the radiation tolerance is increased not only by the base shielding, appropriately biasable, but also by the provision of conductive sidewalls, appropriately biasable, peripherally of the device or of individual chips of the device.

The techniques of deposition, growth, wet or dry etching, doping and masking of layers have not been described in detail. Such techniques are well known and appropriately selectable to carry out the steps described above.

## Claims

1. A semiconductive device comprising a layer (12) of silicon on an insulating layer (11), and a bulk substrate (10), the insulating layer electrically insulating the silicon layer from the bulk substrate, characterized in that the silicon layer has a conductive, non-contiguous sidewall (14), similarly insulated from the bulk substrate by the insulating layer.

2. A device as claimed in claim 1 wherein the insulating layer comprises a silicon oxide layer.

3. A device as claimed in Claim 1 or 2 wherein the sidewall comprises an upstanding wall of polysilicon.

4. A device as claimed in Claim 3, wherein the polysilicon sidewall is doped to enhance its conductivity.

5. A device as claimed in any of claims 1 to 4 wherein there are a plurality of the silicon layers forming islands on the bulk substrate.

6. A device as claimed in any of Claims 1 to 5 wherein the sidewall extends perimetrically of the silicon layer or the respective silicon layer.

7. A device as claimed in any preceding claim wherein the sidewall is electrically connected to a region of the silicon layer constituting a terminal thereof whereby the sidewall may be biased, in use, to a predetermined potential.

8. A device as claimed in any preceding claim wherein the bulk substrate is formed of a conductive material whereby, in use, it may be biased to a desired potential.

9. A method of making a semiconductive device according to any preceding claim comprising the steps of providing a sacrificial (at least in part) insulating coating (13) on exposed upper and side surfaces of a silicon layer (12) mounted on an insulating layer (11) on the surface of a bulk substrate (10), depositing polysilicon (14) on the silicon layer and the surrounding insulating layer, and removing the deposited polysilicon to uncover the sacrificial insulating coating on the upper surface of the silicon layer whilst leaving a sidewall of the polysilicon, separated from the silicon by the sacrificial insulating coating.

10. A method as claimed in Claim 9 wherein there are a plurality of the silicon layers in the form of islands mounted on but insulated from the bulk substrate.

11. A method as claimed in Claim 9 or 10 wherein, after the formation of terminal regions on the silicon layer or layers the or each sidewall is electrically connected to a particular terminal region of the respective layer.

12. A method as claimed in either of claims 10 or 11, wherein one of the polysilicon sidewall extends perimetrically of the or of desired ones of the silicon layers.

**Revendications**

1. Dispositif à semi-conducteur, comprenant une couche (12) de silicium formée sur une couche isolante (11), et un substrat massif (10), la couche isolante assurant l'isolement électrique de la couche de silicium par rapport au substrat massif, caractérisé en ce que la couche de silicium a une paroi latérale conductrice non contiguë (14), isolée de manière analogue par rapport au substrat massif par la couche isolante.

2. Dispositif selon la revendication 1, dans lequel la couche isolante est une couche d'oxyde de silicium.

3. Dispositif selon la revendication 1 ou 2, dans lequel la paroi latérale comporte une paroi perpendiculaire de silicium polycristallin.

4. Dispositif selon la revendication 3, dans lequel la paroi latérale de silicium polycristallin est dopée afin que sa conductivité soit accrue.

5. Dispositif selon l'une quelconque des revendications 1 à 4, dans lequel plusieurs couches de silicium forment des îlots sur le substrat massif.

6. Dispositif selon l'une quelconque des revendications 1 à 5, dans lequel la paroi latérale est disposée à la périphérie de la couche de silicium ou de la couche respective de silicium.

7. Dispositif selon l'une quelconque des revendications précédentes, dans lequel la paroi latérale est connectée électriquement à une région de la couche de silicium constituant une borne, si bien que la paroi latérale peut être polarisée à un potentiel prédéterminé pendant l'utilisation.

8. Dispositif selon l'une quelconque des revendications précédentes, dans lequel le substrat massif est formé d'un matériau conducteur si bien que, pendant l'utilisation, il peut être polarisé au potentiel voulu.

9. Procédé de fabrication d'un dispositif à semi-conducteur selon l'une quelconque des revendications précédentes, comprenant des étapes de formation d'un revêtement isolant consommable (au moins en partie) (13) sur des surfaces supérieure et latérales exposées d'une couche de silicium (12) montée sur une couche isolante (11) à la surface d'un substrat massif (10), le dépôt de silicium polycristallin (14) sur la couche de silicium et la couche isolante qui l'entoure, et l'extraction du silicium polycristallin déposé afin que le revêtement isolant consommable soit découvert à la surface supérieure de la couche de silicium, alors qu'il reste une paroi latérale du silicium polycristallin, séparée du silicium par le revêtement consommable isolant.

10. Procédé selon la revendication 9, dans lequel plusieurs couches de silicium sont sous forme d'îlots montés sur le substrat massif mais isolés de celui-ci.

11. Procédé selon la revendication 9 ou 10, dans lequel, après la formation des régions des bornes sur la couche ou les couches de silicium, la paroi latérale ou chaque paroi latérale est connectée électriquement à une région particulière de borne de la couche respective.

12. Procédé selon l'une des revendications 10 et 11, dans lequel l'une des parois latérales de silicium polycristallin est disposée à la périphérie de la couche de silicium ou de certaines des couches de silicium choisies.

**Patentansprüche**

1. Halbleiteranordnung, aufweisend eine Schicht (12) aus Silicium auf einer isolierenden Schicht (11) und ein Grundsubstrat (10), wobei die isolierende Schicht die Siliciumschicht elektrisch vom Grundsubstrat isoliert,
**dadurch gekennzeichnet,**
daß die Siliciumschicht eine leitende, nicht angrenzende Seitenwand (14) aufweist, die vom Grundsubstrat in ähnlicher Weise durch die isolierende Schicht isoliert ist.

2. Anordnung nach Anspruch 1, in welcher die isolierende Schicht eine Siliciumoxidschicht umfaßt.

3. Anordnung nach Anspruch 1 oder 2, in welcher die Seitenwand eine aufrechtstehende Wand aus Polysilicium umfaßt.

4. Anordnung nach Anspruch 3, in welcher die Polysiliciumseitenwand zur Steigerung ihrer Leitfähigkeit dotiert ist.

5. Anordnung nach einem der Ansprüche 1 bis 4, in welcher mehrere, auf dem Grundsubstrat Inseln ausbildende Siliciumschichten vorgesehen sind.

6. Anordnung nach einem der Ansprüche 1 bis 5, in welcher die Seitenwand sich am Umfang der Siliciumschicht oder der jeweiligen Siliciumschicht erstreckt.

7. Anordnung nach einem vorhergehenden Anspruch, in welcher die Seitenwand an einen Bereich der Siliciumschicht, der hiervon einen Anschluß bildet, elektrisch angeschlossen ist, wodurch die Seitenwand im Betrieb auf ein vorbestimmtes Potential vorgespannt werden kann.

8. Anordnung nach einem vorhergehenden Anspruch, in welcher das Grundsubstrat aus einem leitenden Material gebildet ist, wodurch es im Betrieb auf ein gewünschtes Potential vorgespannt werden kann.

9. Verfahren zum Herstellen einer Halbleiteranordnung nach einem vorhergehenden Anspruch, umfassend die Schritte des Vorsehens einer isolierenden (zumindest teilweise) Opferbeschichtung (13) auf freiliegenden Ober- und Seitenflächen einer Siliciumschicht (12), die auf einer isolierenden Schicht (11) auf der Oberfläche eines Grundsubstrats (10) angebracht ist, des Abscheidens von Polysilicium (14) auf der Siliciumschicht und der umgebenden isolierenden Schicht und der Entfernung des abgeschiedenen Polysiliciums, um die Opferisolationsbeschichtung auf der Oberfläche der Siliciumschicht freizulegen, während eine Seitenwand des Polysiliciums, die vom Silicium durch die Opferisolationsbeschichtung getrennt ist, belassen wird.

10. Verfahren nach Anspruch 9, in welchem mehrere Siliciumschichten in Form von Inseln vorgesehen sind, die auf dem Grundsubstrat angebracht, jedoch hiervon isoliert sind.

11. Verfahren nach Anspruch 9 oder 10, in welchem nach der Ausbildung von Anschlußbereichen auf der Siliciumschicht oder Siliciumschichten die oder jede Seitenwand elektrisch an einen speziellen Anschlußbereich der jeweiligen Schicht angeschlossen wird.

12. Verfahren nach Anspruch 10 oder 11, in welchem eine der Polysiliciumseitenwände sich am Umfang der oder von gewünschten der Siliciumschichten erstreckt.

Fig. 1

Fig 2

Fig 3

Fig 4.

Fig.5

Fig.6

Fig.7

Fig.8

Fig.9